# FASCICULE DE BREVET EUROPEEN

(11) **EP 1 085 520 B1**
(45) Date de publication et mention de la délivrance du brevet: **23.07.2003**
(21) Numéro de dépôt: 00402549.0
(22) Date de dépôt: 15.09.2000
(51) Int. Cl.: G11C 16/10

(54) **Procédé d'écriture en mode page d'une mémoire non volatile électriquement programmable/effaçable et architecture correspondante**
Seitenprogrammiermodus für EEPROM und zugehörige Schaltung
Page mode writing method for an EEPROM and corresponding circuitry

(30) Priorité: 16.09.1999 FR 9911601
(43) Date de publication de la demande: 21.03.2001
(73) Titulaire: STMicroelectronics S.A., 92120 Montrouge (FR)
(72) Inventeur: Naura, David, 94230 Cachan (FR); Zink, Sébastien, 94230 Cachan (FR); Bertrand, Bertrand, 94230 Cachan (FR)
(74) Mandataire: Ballot, Paul

(56) Documents cités:
- US-A- 5 615 149
- US-A- 5 751 637

## Description

La présente invention concerne un procédé d'écriture en mode page d'une mémoire électriquement programmable/effaçable permettant l'écriture de plusieurs mots en mémoire en un seul accès, et une architecture correspondante.

L'invention s'applique notamment aux mémoires de type EEPROM bien connues de l'homme du métier. Elle s'applique plus généralement aux mémoires offrant un mode d'écriture en mode page.

Les architectures mémoires courantes prévoient la possibilité de lire ou d'écrire des informations codées sur plusieurs bits, formant des mots d'information, typiquement des octets (huit bits). Le plan mémoire est alors organisé en colonnes qui regroupent chacune huit lignes de bit Bl₀- Bl₇. De cette manière, on peut accéder simultanément à huit cellules mémoire situées sur la même rangée, qui contiennent des bits d'information D0-D7 correspondant. Toutes les cellules d'une même colonne sont connectées à une ligne de source.

Ainsi, la sélection d'une cellule mémoire donnée passe par l'application de niveaux de tension appropriés sur une rangée, une colonne, une ligne de bit, et une ligne de source, en fonction de l'opération à réaliser sur la cellule mémoire : lecture, effacement (écriture d'un 1), programmation (écriture d'un 0).

On rappelle que l'opération de programmation nécessite une opération d'effacement préalable.

Diverses possibilités d'architectures s'offrent au concepteur, selon les spécifications d'accès à la mémoire.

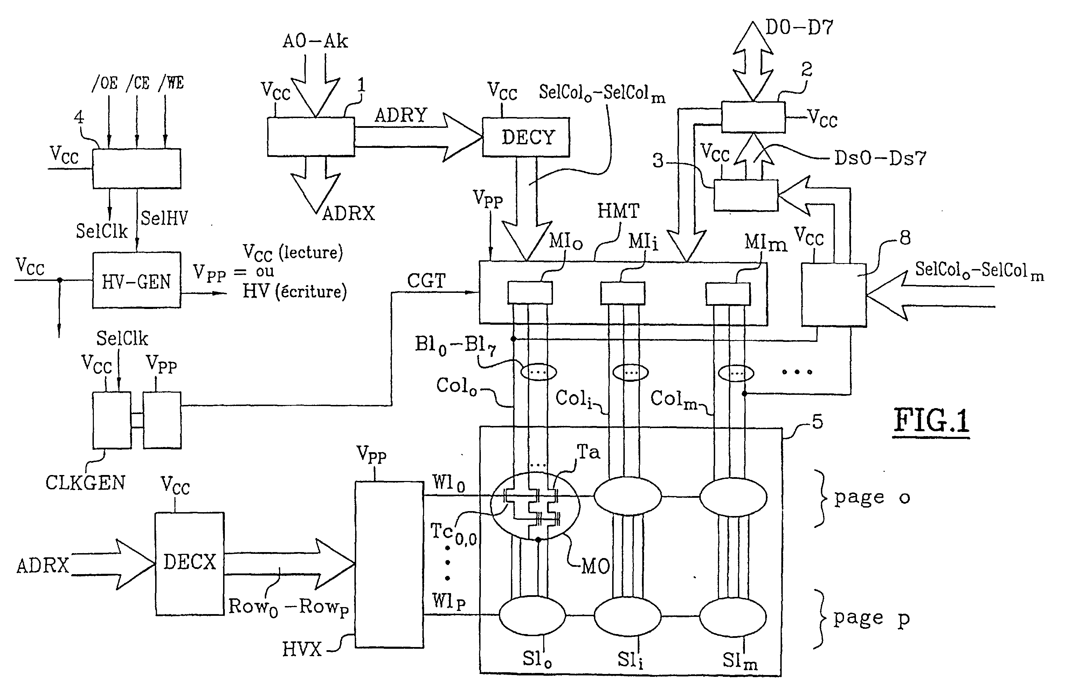

Un exemple d'architecture bien connue est représenté sur la figure 1.

Dans cet exemple, le plan mémoire est organisé en p+1 rangées Wl₀ à Wlₚ et m+1 colonnes Col₀ à Colₘ. A chacune des colonnes sont associées huit lignes de bit Bl₀ à Bl₇. Chaque mot dans la mémoire comprend huit cellules C0, ...C7 placées sur la même rangée.

Le mot mémoire MO correspondant à la rangée Wlo et la colonne Col₀ est détaillé sur la figure 1. Il comprend huit cellules mémoire C0 à C7. Chacune des cellules comprend un transistor d'accès Ta en série avec un transistor à grille flottante Tf. Le transistor d'accès Ta est connecté sur sa grille à la rangée correspondante Wl₀ et sur son drain, à la ligne de bit correspondante, par exemple Bl₀ pour la cellule C0. Un transistor d'accès supplémentaire Tc_{0,0} a sa grille connectée à la rangée Wl₀ correspondante et son drain à la colonne correspondante, Col₀. Sa source est connectée à la grille de contrôle de chacun des transistors à grille flottante Tf des cellules C0 à C7 du mot considéré. Enfin, les sources de ces transistors Tf sont connectées en commun à une ligne de source Slₒ associée à la colonne Col₀. Dans l'exemple, on a une ligne de source Sl₀, ... Slₘ par colonne Col₀,..., Colₘ du plan mémoire.

Dans l'invention, on s'intéresse plus particulièrement à un mode d'accès de la mémoire, par lequel il est possible d'écrire la mémoire page par page, chaque page correspondant à un groupe de mots de la mémoire. Dans l'état de la technique, chaque page correspond à une rangée du plan mémoire. Dans l'exemple, il y a donc p+1 pages correspondant aux p+1 rangées Wl₀ à Wlₚ.

D'une manière simplifiée, en mode page, il suffit à un utilisateur de présenter l'adresse de la page à écrire sur le bus d'adresse externe, puis successivement toutes les données à écrire sur le bus de données externe du circuit mémoire. Des moyens internes spécifiques du circuit mémoire assurent ensuite le séquencement nécessaire à l'effacement et la programmation des cellules mémoire de la page adressée. Notamment, ces moyens internes comprennent une mémoire temporaire pour mémoriser les données à écrire. Les éléments de cette mémoire temporaire sont généralement des bistables, encore appelés latchs. Les moyens d'écriture en mode page nécessitent ainsi au moins autant de latchs que de bits de données à écrire dans une page et des moyens d'application des niveaux de tension appropriés sur les cellules en fonction du contenu de ces latchs. Les opérations d'effacement et de programmation nécessitent l'utilisation d'une haute tension appliquée de manière appropriée sur une ou des lignes d'accès aux cellules, notamment sur les colonnes et lignes de bit.

En particulier, ces moyens d'écriture doivent permettre d'appliquer la haute tension sur les lignes de bit du plan mémoire pour lesquelles une donnée est à écrire (opération d'effacement).

La mémoire temporaire doit en outre comprendre un latch supplémentaire par colonne, permettant d'appliquer également la haute tension sur les colonnes de la mémoire. Ceci est nécessaire pour réaliser l'opération d'effacement des cellules avant leur programmation.

Pour ces différentes raisons, tous les éléments de la mémoire temporaire sont du type haute tension, pour pouvoir assurer la commutation de la haute tension sur les lignes de bit et les colonnes.

Sur la figure 1, on a ainsi représenté une architecture de l'état de la technique avec les éléments concernés par le mode d'écriture par page, notamment la mémoire temporaire.

Dans cette architecture on retrouve les circuits habituels permettant l'accès en lecture et en écriture à la mémoire. On a ainsi un registre d'adresse 1 recevant les signaux d'adresse A0-Ak du bus d'adresse externe et fournissant des signaux d'adresse internes ADRX, ADRY à différents circuits de décodage. Un registre de données 2 reçoit les signaux externes de données d'entrée/sortie D0-D7 du bus de donnée externe.

Ce registre de données délivre en interne des signaux de données Di0-Di7 correspondant aux données externes qu'il reçoit. Il reçoit en interne des signaux de données de sortie Ds0-Ds7 du circuit amplificateur de lecture 3 de la mémoire non volatile.

Un circuit logique de contrôle général 4 de la mémoire commande de façon appropriée les différents éléments de circuits internes: décodeur de rangée DECX et commutateur haute tension associé HVX, décodeur de colonne DECY, circuit amplificateur de lecture 3, générateur de haute tension VPP HVGEN, générateur CLKGEN de signaux logiques de phase, mémoire temporaire de type haute tension HMT, ..., en fonction des signaux externes qu'il reçoit : signaux de commande de sélection de boîtier /CE, de validation de sortie de données /OE et d'écriture /WE.

Pour accéder au plan 5 de cellules mémoire, le circuit comprend habituellement un décodeur de rangée DECX pour sélectionner une rangée parmi les rangées Wl₀-Wlₚ du plan mémoire et un décodeur de colonne DECY, pour sélectionner une ou des colonnes Col₀-Colₘ du plan mémoire. Le décodeur de rangées fournit des signaux logiques de sélection Row₀,..., Rowₚ au commutateur haute tension HVX qui applique en sortie les niveaux de tension appropriés sur les rangées, en fonction du mode d'accès. Le décodeur de colonne DECY fournit des signaux logiques de sélection Selcol₀,..., Selcolₘ. Ces signaux sont appliqués notamment à un circuit porte de lecture 8 pour connecter un groupe de lignes de bit Bl₀,...,Bl₇, au circuit 3 amplificateur de lecture. Dans l'exemple, ces signaux de sélection de colonne sont aussi appliqués à la mémoire temporaire.

La mémoire temporaire, notée HMT, peut mémoriser m+1 mots MI0 à MIm correspondant à une page de la mémoire, soit un mot d'information par colonne. Chaque mot d'information MIi comprend un bit d'information de sélection de la colonne correspondante et huit bits d'information correspondant à la donnée à écrire, le cas échéant. Les bits d'information de sélection de colonne sont fournis par les signaux de sélection de colonne SelCol₀ à SelColₘ fournis en sortie par le décodeur de colonne DECY. Les huit autres bits d'information sont fournis par le bus interne d'entrée de données (signaux Di0 à Di7).

Dans l'exemple, la mémoire temporaire comprend donc 9.(m+1) latchs haute tension. Si m=15 (cas typique des mémoires de capacité 2KO, avec 16 rangées et 16 colonnes), cela fait 144 latchs haute tension.

Pour l'écriture de la mémoire non volatile en fonction des mots d'information préalablement enregistrés dans les latchs de la mémoire HMT, ces derniers sont commandés au moyen d'un signal de commande haute tension, CGT, fourni par le circuit de génération de signaux de phase CLKGEN. On applique ainsi la tension de programmation sur toutes les lignes de bit. Le mode page permet ainsi l'écriture de m+1 mots de la mémoire en seulement une fois le temps nécessaire à l'écriture d'une cellule mémoire, ce qui est très utile par exemple dans les applications où de nombreuses données doivent être écrites périodiquement.

Cependant les latchs haute tension sont des éléments dont l'implantation physique dans un circuit intégré utilise beaucoup de place. Par exemple, dans un circuit mémoire d'une capacité mémoire de 2 Kilooctets, les latchs haute tension nécessaires à la mise en oeuvre du mode page prennent autant de place sur le circuit que le plan mémoire lui-même.

Ceci est un gros inconvénient, notamment pour l'élaboration de circuits mémoire à faible capacité (2KO) et faible coût.

Le document US 5, 363, 330 propose une architecture dans laquelle les latchs haute tension de la mémoire temporaire sont remplacés par des latchs basse-tension, moins encombrants, l'écriture étant assurée par un séquencement approprié de commutateurs de type translateur haute tension et multiplexeurs haute tension. Cette architecture permet de réduire l'encombrement mémoire, mais la durée d'écriture est nettement plus longue.

Dans l'invention, on a cherché un autre moyen pour réduire le nombre de latchs haute tension nécessaire à la mise en oeuvre du mode page.

L'idée à la base de l'invention réside dans le changement de concept de page : dans l'invention, une page ne correspond plus à une rangée de la mémoire mais à une colonne. Ce changement de concept de mode page associé à une mémoire temporaire alimentée sous la tension d'alimentation logique et non plus en haute tension, permet d'atteindre les objectifs de réduction du coût des mémoires concernées sans trop pénaliser le temps d'accès en mode page.

Telle que caractérisée, l'invention concerne donc un procédé d'écriture en mode page dans une mémoire non volatile électriquement effaçable et programmable dans un circuit intégré, comprenant un plan mémoire organisé matriciellement en colonnes et rangées de mots mémoire, chaque mot mémoire comprenant une pluralité de cellules mémoire chacune associée à une ligne de bit, un décodeur de rangée et un décodeur de colonne fournissant respectivement des signaux de sélection de rangées et de colonnes permettant l'application de niveaux de tension appropriés pour l'accès en lecture ou en écriture au plan mémoire, des moyens d'écriture en mode page comprenant une mémoire temporaire pour mémoriser les données à écrire dans la page. Selon l'invention, le procédé comprend la sélection d'une colonne de la mémoire comme page à écrire.

Selon une caractéristique de l'invention, Le procédé d'écriture en mode page comprend :
- une phase d'initialisation, comprenant l'écriture d'une information de sélection de la page à écrire dans un latch de mémorisation associé à une colonne du plan mémoire non volatile, et l'écriture dans une mémoire temporaire de chacune des données à écrire dans la page,
- une phase d'écriture comprenant la sélection de rangées du plan mémoire non volatile en fonction du contenu de la mémoire temporaire.

L'invention concerne aussi une architecture d'une mémoire non volatile électriquement programmable et effaçable dans un circuit intégré, dans laquelle une page d'écriture correspond à une colonne de la mémoire.

D'autres caractéristiques et avantages de l'invention sont décrits dans la description suivante d'un mode de réalisation de l'invention, faite à titre illustratif et non limitatif, et en référence aux dessins annexés dans lesquels :
- la figure 1 représente un schéma bloc général d'un circuit mémoire de type EEPROM mettant en oeuvre un mode page selon l'état de la technique;
- la figure 2 représente un schéma bloc général d'un circuit mémoire de type EEPROM mettant en oeuvre un mode page selon l'invention;
- la figure 3 est un schéma plus détaillé d'une mémoire utilisée dans l'invention;
- la figure 4 représente les latchs et les circuits de commutation haute tension utilisés en mode page dans le circuit mémoire selon l'invention;
- la figure 5 est un schéma détaillé d'un latch haute tension utilisé dans l'invention.
- la figure 6 représente un schéma bloc du circuit de contrôle d'écriture en mode page selon l'invention;
- la figure 7 représente de façon plus détaillée le circuit de génération des signaux de sélection de rangées du plan mémoire par le circuit de contrôle de la figure 6;
- la figure 8 est un chronogramme des phases d'effacement/programmation en mode page selon l'invention; et
- les figures 9a et 9b sont des schémas simplifiés indiquant les tensions de polarisation appliquées aux cellules mémoire respectivement en effacement et en programmation.

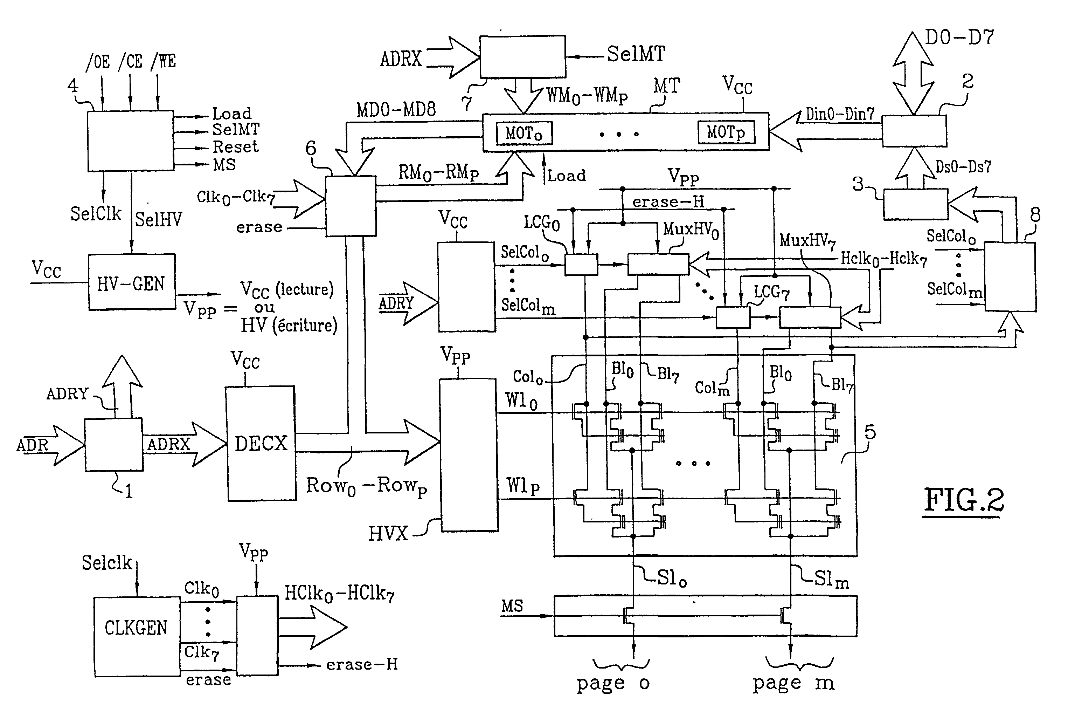

La figure 2 représente un exemple d'architecture d'un circuit mémoire mettant en oeuvre un procédé d'écriture en mode page selon l'invention. Dans l'exemple, il s'agit d'un circuit mémoire à accès parallèle plus particulièrement concerné par ce mode d'accès.

L'invention s'applique aussi bien à un circuit mémoire à accès série.

Sur la figure 2, les éléments communs à la figure 1 portent les mêmes références. Notamment le plan mémoire 5 est inchangé.

Le procédé d'écriture en mode page selon l'invention permet de gérer l'écriture d'un, de plusieurs ou de tous les mots mémoire d'une colonne du plan de la mémoire. Selon ce procédé, une page correspond à une colonne du plan mémoire. Dans l'exemple d'architecture représentée sur la figure 2, On a ainsi m+1 pages correspondant aux m+1 colonnes Col₀, ..., Colₘ du plan mémoire 5.

Ceci permet de diminuer le nombre de latchs haute tension nécessaire à l'effacement et la programmation des cellules mémoire des mots de la page considérée, puisqu'il permet l'utilisation du commutateur haute tension HVX associé au décodeur de rangées DECX, avec une sélection sélective des rangées de la mémoire à écrire en fonction du contenu des mots en mémoire temporaire.

Dans le cas plus particulièrement représenté qui permet d'écrire seulement certains mots de la page, les mots contenus en mémoire temporaire contiennent chacun un bit de position du mot dans la page et des bits d'information correspondant à la donnée à écrire.

Dans ce contexte, selon le procédé d'écriture en mode page selon l'invention, on efface toutes les cellules mémoire des rangées pour lesquelles l'analyse du contenu de la mémoire temporaire indique un bit de position correspondant activé, et parmi ces rangées, on ne programme ligne de bit par ligne de bit que les rangées pour lesquelles l'analyse du contenu mémoire montre un bit d'information correspondant à 0.

Si l'on ne prévoit pas la possibilité d'écrire seulement certains mots de la page, l'effacement de la colonne se fait de manière globale, pour toutes les rangées. Dans ce cas, il n'y a pas à analyser le contenu de la mémoire temporaire.

Ainsi, selon le procédé d'écriture de l'invention, le décodeur de rangée DECX est désélectionné au profit d'un circuit qui analyse le contenu de la mémoire temporaire pour fournir en sortie les signaux de sélection de rangées.

Une architecture correspondante comprend ainsi une mémoire temporaire MT alimentée sous la tension d'alimentation logique Vcc du circuit pour contenir les données à écrire en mémoire, un circuit 6 de contrôle d'écriture de la mémoire non volatile en mode page, apte à générer les signaux de sélection de rangées Row₀-Rowₚ en fonction du contenu de la mémoire temporaire MT, et un latch LCG₀-LCG_{M} par colonne Col₀-Colₘ du plan mémoire non volatile 5, pour mémoriser une information de sélection de page.

La mémoire temporaire MT peut typiquement comprendre des éléments mémoire de type bistable ou latch.

Comme une page selon l'invention correspond à une colonne, cette mémoire temporaire MT comprend autant d'éléments mémoire MOT0-MOTp que de rangées Wl₀-Wlₚ du plan mémoire non volatile, soit p+1 dans l'exemple.

Dans une phase d'initialisation de l'écriture en mode page, cette mémoire temporaire MT reçoit les données à écrire par le bus interne d'entrée de données Di0-Di7. Elle est gérée en écriture par un circuit logique 7 qui reçoit les signaux d'adresse ADRX et fournit en sortie un signal d'écriture, Load, et des signaux de sélection en écriture WM₀-WMₚ, qui chacun permettent d'écrire à une position correspondante les bits d'information de la donnée présentée en entrée Di0-Di7 et de positionner un bit de position correspondant. A la fin de la phase d'initialisation, et pour chaque adresse de position présentée sur le bus d'adresse externe, la mémoire temporaire contient les bits d'information de la donnée correspondante présentée sur le bus d'adresse externe, et un bit d'information de position activé.

Dans l'exemple, le bit MD0 correspond au bit d'information de position POSBIT et les bits MD1-MD8 correspondent aux bits d'information DATABIT₀, ..., DATABIT₇ à écrire en mémoire non volatile, chacun sur la ligne de bit correspondante Bl₀, ..., B₇.

Le bit d'information de position est positionné par le signal de sélection d'écriture correspondant de la mémoire temporaire. Par exemple, dans le mot mémoire MOT₀, il est positionné à 1 par le signal WM₀ si une adresse correspondante a été reçue. Ceci permet une écriture de tout ou partie d'une page, l'analyse du bit de position permettant de dire si la donnée correspondante est à prendre en compte ou non. Si on ne doit pas mettre en oeuvre cette possibilité de n'écrire la page qu'en partie, toute la logique associée au bit de position est à supprimer.

Un signal de réinitialisation Reset permet de remettre à zéro tous les éléments de la mémoire temporaire. Il est activé par le circuit de contrôle général 4 à chaque mise sous tension du circuit intégré et à chaque nouvelle écriture en mode page.

Enfin, la mémoire temporaire MT reçoit des signaux de sélection en lecture RM₀-RM₇ appliqués par le circuit 6 de contrôle d'écriture en mode page, permettant la sélection et la lecture des bits MD0-MD8 d'un mot de la mémoire temporaire. Ces bits d'information sont reçus par le circuit 6 de contrôle d'écriture en mode page, aux fins d'analyse du contenu de la mémoire temporaire.

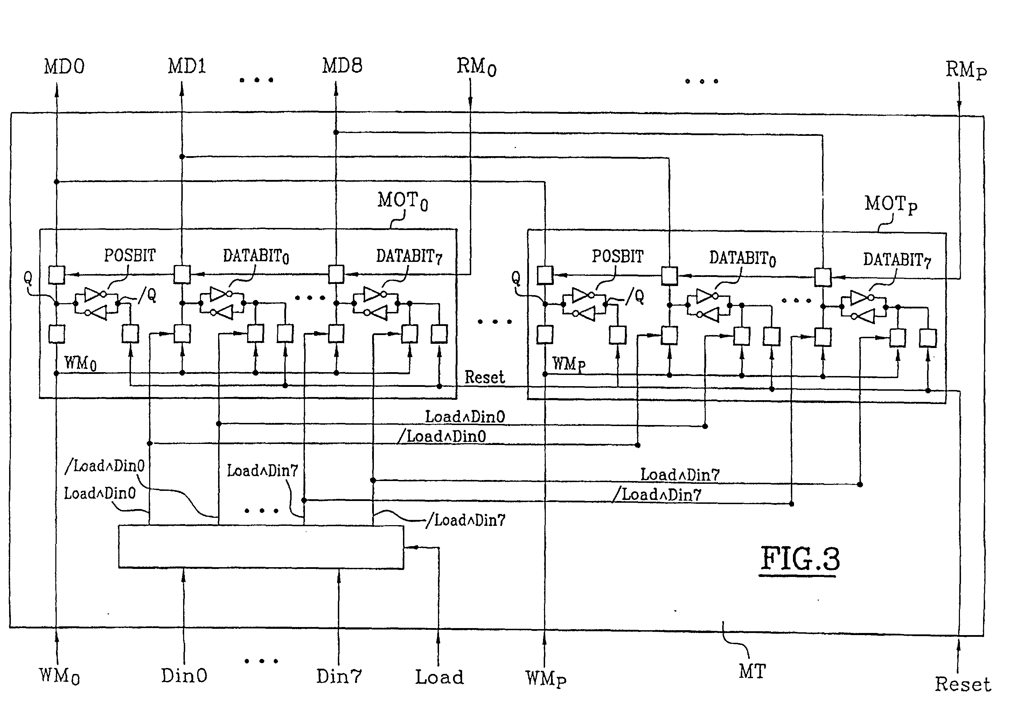

Un exemple de mémoire temporaire MT est détaillé sur la figure 3. Il comprend p+1 éléments mémoire MOT0 à MOTP. Chaque mot comprend dans l'exemple 1+8 bits d'information. Le premier bit d'information est le bit d'information POSBIT de position de mot dans la page, les huit bits suivants DATABIT0-DATABIT7 correspondent aux bits d'information à écrire en mémoire non volatile.

Chaque bit est mémorisé dans un élément de type latch (bistable) avec deux noeuds d'entrée/sortie Q et /Q.

Pour le bit de position de mot POSBIT, le circuit de mise à 1 connecté sur le noeud Q, est commandé par le signal de sélection d'écriture du mot correspondant, WM₀ pour l'élément MOT0.

Le circuit de mise à zéro connecté sur le noeud /Q est commandé par le signal Reset.

Le circuit de lecture est dans l'exemple connecté entre le noeud Q et la ligne de sortie de donnée correspondante MD0, et commandé par le signal de sélection en lecture correspondant RM₀.

Pour les autres bits d'information, on a un premier circuit de mise à 1, connecté au noeud Q, et commandé par un signal LoadΛDin0, et un deuxième circuit de mise à 1, connecté au noeud /Q et commandé par le signal complémentaire /LoadΛDin0. Les signaux LoadΛDin0 et /LoadΛDin0 sont fournis par un circuit de validation d'écriture des données d'entrées Din₀,...,Din₇. Ce circuit reçoit les données d'entrée et le signal de validation d'écriture Load, et effectue dans l'exemple, un ET logique entre chacun des bits de données et le signal de validation pour fournir, pour chacun des latchs, le signal d'écriture. Un inverseur fournit le signal complémentaire.

Un circuit de remise à zéro sur le noeud /Q et un circuit de lecture sur le noeud Q sont aussi prévus, identiques à ceux du bit de position. Les données de sortie MD1 à MD8 correspondent ainsi aux bits d'information DATABIT₀ à DATABIT₇ de la mémoire temporaire.

Le circuit 6 de contrôle d'écriture en mode page reçoit en entrées les signaux de phase Clk0-Clk7, ainsi que les bits de données de sortie MD0-MD8 de la mémoire temporaire, dont il gère l'accès en lecture en générant les signaux de sélection en lecture RM₀-RM₇.

Il fournit en sortie les signaux de sélection de rangée Row₀-Rowₚ de la mémoire non volatile en fonction du contenu de la mémoire temporaire. Ce circuit sera détaillé plus loin.

Les moyens d'écriture en mode page comprennent pour chaque colonne, un latch (registre) LCG₀,...,LCGₘ pour mémoriser une information de sélection de page et un circuit multiplexeur haute tension MUXHV₀,..., MUXHVₘ.

Le circuit multiplexeur haute tension permet d'appliquer successivement la haute tension sur chacune des lignes de bit Bl₀-Bl₇ de la colonne correspondante selon le séquencement des signaux de phase haute tension HClk₀-HClk_{7,} lors de la phase de programmation ligne de bit par ligne de bit.

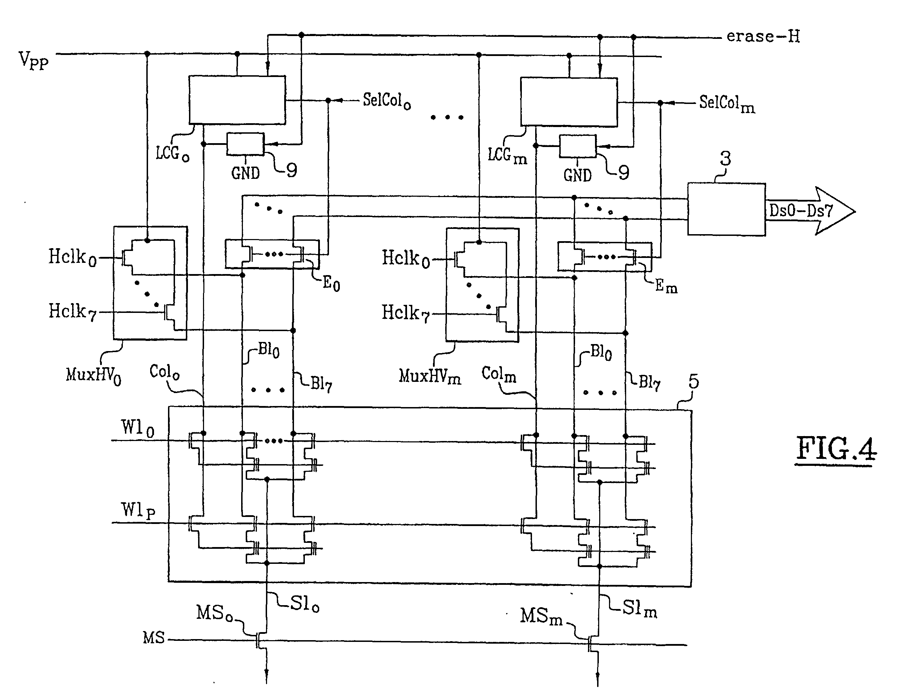

Ces éléments sont détaillés sur la figure 4.

Chaque multiplexeur haute tension MUXHV₀,...,MUXHVₘ comprend un transistor de commutation de la haute tension par ligne de bit Bl₀,...,Bl₇, commandé par un signal de phase haute tension correspondant HClk₀,..., HClk₇.

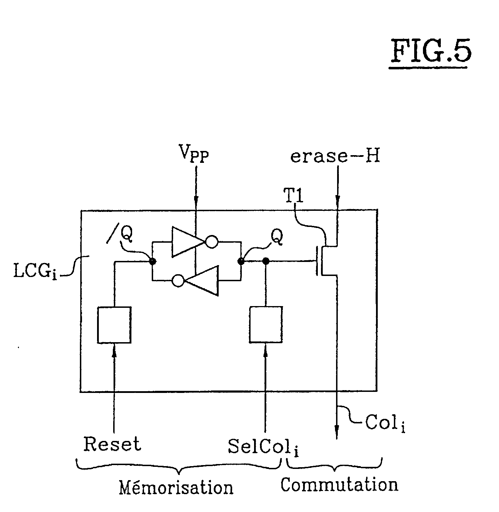

Les latchs de mémorisation de la sélection de page sont aussi des latchs haute tension. On a un latch de mémorisation de la sélection de page par colonne. Comme détaillé sur la figure 5, chaque latch CGHVᵢ comprend un étage de mémorisation de type bistable alimenté en haute tension VPP. Le circuit de mise à 1 est commandé par le signal de sélection de colonne correspondant SelColᵢ fourni par le décodeur de colonne DECY de la mémoire non volatile. Le circuit de remise à zéro connecté au noeud d'entrée/sortie /Q est commandé par le signal de réinitialisation Reset. Chaque latch comprend en outre un étage de commutation de la haute tension sur la colonne correspondante. Dans l'exemple, cet étage de commutation comprend un transistor T1 commandé sur sa grille par la sortie Q du bistable correspondant à la mise à 1, pour commuter le niveau d'un signal de commande d'effacement en haute tension erase-H sur la colonne correspondante.

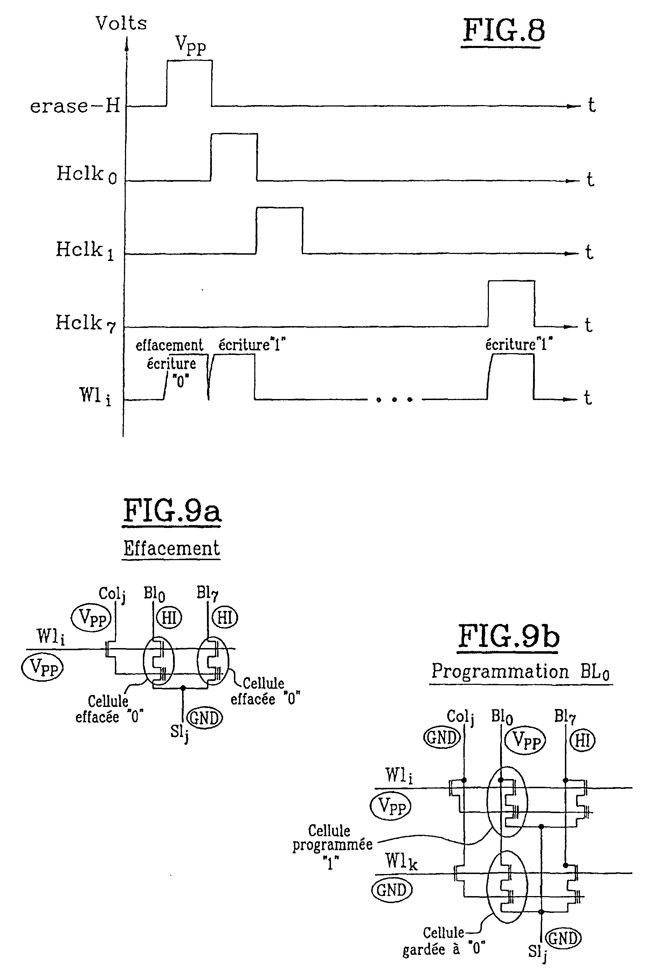

Ce signal de commande d'effacement en haute tension erase-H est typiquement fourni à partir d'un signal logique de commande d'effacement erase généré par le circuit de génération d'horloge CLKGEN. Dans l'exemple, il est au niveau 1 (V_{PP}) pendant la phase d'effacement. Il passe ensuite à 0, pendant la phase de programmation, comme montré sur la figure 8.

Sur la figure 4, on a représenté en outre un circuit 9 de mise à la masse des colonnes, piloté par le signal erase-H. Il comprend dans l'exemple, un transistor par colonne, connecté entre cette colonne et la masse (Gnd) du circuit et activé sur le niveau 0 du signal de commande erase-H. Ainsi, les colonnes du plan mémoire non volatile sont toutes tirées à la masse pendant la phase de programmation, comme on le verra plus loin avec le chronogramme de séquencement des signaux et le détail des niveaux appliqués aux cellules mémoire non volatile (figures 8 et 9).

Le circuit porte de lecture 8 qui permet de connecter les lignes de bit d'une colonne au circuit amplificateur de lecture 3 est détaillé sur la figure 4. Il comprend un étage par colonne, soit m+1 étages E₀ à Eₘ. Chacun est associé à une colonne correspondante pour connecter les lignes de bit de cette colonne Bl₀₋-Bl7 aux amplificateurs de lecture du circuit 3 de sortie de données selon le signal de sélection de colonne correspondant.

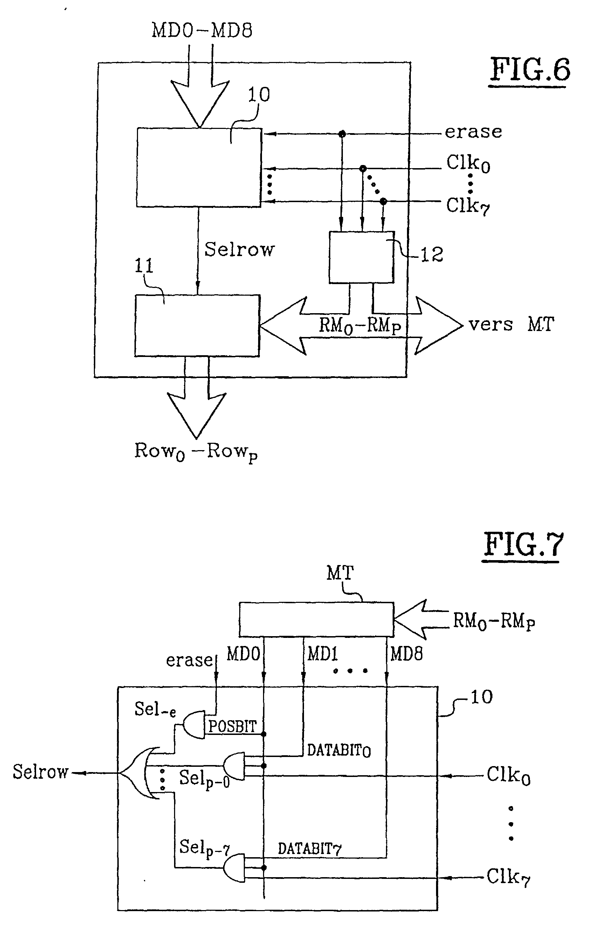

Le circuit 6 de contrôle d'écriture en mode page est détaillé sur la figure 6 qui représente un schéma bloc général et sur la figure 7 qui montre un exemple détaillé de réalisation de l'étage logique d'analyse du contenu de la mémoire temporaire.

Le circuit 6 de contrôle d'écriture en mode page comprend un étage logique 10, un circuit démultiplexeur 11 et un circuit de séquencement 12.

L'étage logique reçoit en entrée les données de sortie MD0 à MD8 de la mémoire temporaire, les signaux logiques de phase Clk₀ à Clk₇, et le signal logique de commande d'effacement, erase. Cet étage logique délivre en sortie une information de sélection de rangée Selrow. Cette information de sélection de rangée est appliquée en entrée sur un circuit démultiplexeur 11, qui commute cette information en sortie sur l'un des signaux de sélection de rangée Row₀ à Rowₚ, en fonction des signaux de sélection de lecture RM₀ à RMₚ appliqués par le circuit de séquencement 12 sur la mémoire temporaire MT.

Le circuit de séquencement 12 peut typiquement être un compteur de 0 à p. Il est activé par les signaux logiques de commande d'effacement, erase et de phase, Clk₀ à Clk₇. En effet, que ce soit pour la phase d'effacement ou pour chacune des étapes de programmation, il faut analyser à chaque fois tout le contenu de la mémoire non volatile pour sélectionner sélectivement les rangées. Ainsi, pour chacune de ces étapes, il faut régénérer successivement les signaux de sélection de lecture RM₀ à RMₚ de la mémoire temporaire, pour lire séquentiellement les données contenues dans cette mémoire temporaire, et pour chacune de ces données, décider dans l'étage logique 10 de la sélection ou non de la rangée correspondant au rang du mot lu dans la mémoire temporaire, pour la phase considérée.

Si on considère que les signaux logiques de commande d'effacement erase et de phase Clk₀ à Clk₇ sont tous actifs sur le niveau 1, il suffit de faire un OU logique de tous ces signaux pour réarmer le compteur à chaque phase.

Un exemple de réalisation de l'étage logique est représenté sur la figure 7. Dans cet exemple, les bits d'information de position sont valides à 1. Les bits d'information à 1 correspondent à une donnée à programmer, (écriture d'un 1) et les bits d'information à 0, à une donnée à effacer (écriture d'un 0.

Dans la phase d'effacement, il faut identifier les rangées dans lesquelles on a un mot à écrire. Le contenu du mot à écrire est indifférent : une fois effacés, on regardera les bits à écrire à 1 pour ne programmer que ceux-là et les autres resteront effacés (écrits à 0).

Dans cette phase séquencée par le signal de commande logique d'effacement erase, il faut donc seulement regarder le bit de position de chaque mot pour sélectionner les rangées pour lesquelles le bit de position du mot de rang correspondant dans la mémoire temporaire aura été positionné à 1.

Dans chacune des phases Clk₀ à Clk₇ de programmation, il faut regarder dans chaque mot de la mémoire temporaire l'état du bit d'information de même rang que la ligne de bit considérée, pour sélectionner les rangées pour lesquelles ce bit est lu à 1.

Cette logique de sélection peut être réalisée de manière simple par des portes combinatoires. Pour chaque niveau de décision, on a une porte logique ET : une première porte reçoit le bit MD0 correspondant au bit de position POSBIT et le signal logique de commande d'effacement erase et fournit en sortie un signal de décision Sel-e de niveau 1 si l'on est en phase d'effacement (erase à 1) et si le bit est positionné. Une deuxième porte logique reçoit le bit MD1 correspondant au bit d'information DATABIT₀, le bit MD0 correspondant au bit de position POSBIT et le signal logique de phase Clk₀. Elle fournit en sortie un signal de décision Sel-p0 de niveau 1 si l'on est en phase de programmation de la ligne Bl₀ (Clk₀ à 1), si le bit de position est positionné, indiquant que les bits d'information sont valides, et si le bit d'information est lui-même à 1, signifiant qu'il faut une programmation. Les autres portes logiques pour les autres bits de données MD2 à MD8 sont identiques à cette deuxième porte, et commandées par le signal logique de phase correspondant Clk₁ à Clk₇. On obtient donc neuf signaux de sortie Sel-e, Sel-p0,...Sel-p7. Ces signaux sont tous actifs à 1.

Dans l'exemple, ils sont combinés dans une porte ou logique pour fournir en sortie l'information de sélection de rangée Selrow. Si l'on est dans la séquence de lecture du ième mot MOTi de la mémoire temporaire, commandée par le signal de sélection de lecture RMᵢ, le démultiplexeur 12 applique alors l'information Selrow sur le signal de sélection de rangée Rowi correspondant.

Le séquencement d'une écriture en mode page selon l'invention est représenté sur la figure 8, et les niveaux appliqués sur une cellule mémoire en effacement et en programmation sont indiqués sur les figures 9a et 9b.

Lors de la phase d'effacement (figure 9a), une rangée Wlᵢ sélectionnée par le circuit 6 de contrôle reçoit la haute tension VPP pendant cette phase. La colonne sélectionnée, Col₀ par exemple sur la figure 9a, reçoit aussi la haute tension par le latch de sélection de page positionné à 1. Les autres latchs étant toujours à 0, les autres colonnes sont en haute impédance HI. Ainsi, seuls les mots de la colonne sélectionnée correspondant aux rangées sélectionnées sont effacées.

En fin de phase d'effacement, le signal erase-H passe à zéro. La phase de programmation débute. Les colonnes sont tirées à la masse (GND) par le circuit 9. La phase de programmation comprend huit étapes de programmation, une par ligne de bit, chacune séquencée par un signal logique de phase correspondant.

Lors de l'étape de programmation de la première ligne de bit Bl₀, les lignes de bit Bl₀ du plan mémoire reçoivent la haute tension V_{PP}, et les autres lignes de bit sont en haute impédance, niveaux imposés par les multiplexeurs MUXHV₀ à MUXHVₘ séquencés par les signaux de phase haute tension HClk₀ à HClk₇. Une rangée Wlᵢ sélectionnée en programmation dans cette étape par le circuit de contrôle 6 reçoit la haute tension V_{PP}, tandis qu'une rangée Wlₖ non sélectionnée en programmation dans cette étape par le circuit de contrôle 6 est mise à la masse. Et ainsi de suite pour chacune des huit étapes de programmation.

Sur la figure 8, on voit ainsi que le signal Wlᵢ est à VPP en phase d'effacement (erase à 1), puis tantôt à V_{PP}, tantôt à 0, selon que l'on doit y écrire un 1 ou un 0.

L'invention qui vient d'être décrite permet de réduire le nombre d'éléments haute tension nécessaire à l'écriture en mode page : il ne comporte plus que m+1 latchs haute tension et m+1 multiplexeurs haute tension, le circuit logique de contrôle 6 permettant l'utilisation du commutateur haute tension HVX des rangées.

Le temps d'accès en mode page est un peu augmenté du fait du séquencement nécessaire à l'analyse de la mémoire statique, mais reste tout à fait satisfaisant, de l'ordre de 10ms.

L'architecture décrite plus particulièrement n'est qu'un exemple illustratif de l'invention. D'autres architectures sont possibles. Des variantes dans le procédé d'écriture sont aussi possibles. Notamment, on peut prévoir dans la phase d'initialisation, d'écrire la mémoire temporaire avec le contenu de la colonne mémoire non volatile sélectionnée en mode page, les données présentées en écriture pour le mode page étant alors utilisées pour modifier le contenu de la mémoire temporaire. Dans ce cas, on fera un effacement global de la colonne, puis une programmation sélective selon le principe de l'invention. On peut aussi ne pas permettre l'écriture de seulement une partie de la mémoire, cas dans lequel l'effacement sera là encore global. Toutes ces variantes restent du domaine de l'invention.

## Revendications

1. Procédé d'écriture en mode page dans une mémoire non volatile électriquement effaçable et programmable dans un circuit intégré, comprenant un plan mémoire (5) organisé matriciellement en colonnes (Col₀, ..., Colₘ) et rangées (Wl₀, ..., Wlₚ) de mots mémoire, chaque mot mémoire comprenant une pluralité de cellules mémoire (C0,...,C7) chacune associée à une ligne de bit (Bl₀,...,Bl₇), un décodeur de rangée (DECX) et un décodeur de colonne (DECY) fournissant respectivement des signaux de sélection de rangées (Row₀, ...Rowₚ) et de colonnes (Selcol₀,...Selcolₘ) permettant l'application de niveaux de tension appropriés pour l'accès en lecture ou en écriture au plan mémoire, des moyens d'écriture en mode page comprenant une mémoire temporaire (MT) pour mémoriser les données à écrire dans une page, **caractérisé en ce que** le procédé comprend la sélection d'une colonne de la mémoire comme page à écrire.

2. Procédé d'écriture selon la revendication 1, **caractérisé en ce qu'**il comprend :
- une phase d'initialisation, comprenant l'écriture d'une information de sélection de la page à écrire dans un latch de mémorisation associé à une colonne du plan mémoire non volatile et l'écriture dans une mémoire temporaire (MT) de chacune des données à écrire dans la page,
- une phase d'écriture du contenu de la mémoire temporaire (MT) dans la page sélectionnée.

3. Procédé d'écriture selon la revendication 2, **caractérisé en ce qu'**il comprend l'utilisation d'un latch haute tension par colonne du plan mémoire non volatile pour mémoriser l'information de sélection de page.

4. Procédé d'écriture selon la revendication 3, **caractérisé en ce que** dans la phase d'initialisation, le décodeur de colonne (DECY) reçoit en entrée une adresse de colonne et fournit en sortie un signal de sélection de colonne (Selcolᵢ) correspondant déclenchant l'écriture du bit d'information de sélection de page dans le latch haute tension correspondant (LCGᵢ).

5. Procédé d'écriture selon l'une des revendications précédentes, **caractérisé en ce que** la phase d'écriture comprend une phase d'effacement et une phase de programmation et **en ce que** la phase de programmation est effectuée ligne de bit par ligne de bit de la colonne sélectionnée, chaque étape de programmation d'une ligne de bit comprenant la génération des signaux de sélection de rangées (Row₀,...Rowₚ) en fonction du bit d'information correspondant dans chacun des mots contenus en mémoire temporaire.

6. Procédé selon la revendication 5, **caractérisé en ce que** chaque mot dans la mémoire temporaire (MT) comprend des bits d'information (DATABIT₀, ..., DATABIT₇) correspondant à la donnée à écrire et un bit de position (POSBIT) du mot dans la page et **en ce que** la phase d'effacement comprend la génération des signaux de sélection de rangées (Row₀,...Rowₚ) en fonction des bits d'information de position contenus en mémoire temporaire.

7. Procédé d'écriture selon la revendication 6, **caractérisé en ce que** la génération des signaux de sélection de rangées (Row₀,...Rowₚ) dans chaque étape de programmation d'une ligne de bit est en outre fonction du bit de position dans chacun des mots contenus en mémoire temporaire.

8. Procédé d'écriture selon l'une des revendications 5 à 7 précédentes, **caractérisé en ce que** dans la phase d'effacement, l'information de sélection de page mémorisée dans un des latchs de sélection de page permet l'application d'une haute tension sur la colonne ainsi sélectionnée.

9. Architecture d'une mémoire non volatile électriquement programmable et effaçable dans un circuit intégré, comprenant un plan mémoire (5) organisé matriciellement en colonnes (Col₀, ..., Colₘ) et rangées (Wl₀, ..., Wlₚ) de mots mémoire, chaque mot mémoire comprenant une pluralité de cellules mémoire (C0,...,C7) chacune associée à une ligne de bit (Bl₀,...,Bl₇), un décodeur de rangée (DECX) et un décodeur de colonne (DECY) fournissant respectivement des signaux de sélection de rangées (Row₀,...Rowₚ) et de colonnes (Selcol₀,...Selcolₘ) permettant l'application de niveaux de tension appropriés pour l'accès en lecture ou en écriture au plan mémoire, des moyens d'écriture en mode page des moyens d'écriture en mode page comprenant une mémoire temporaire (MT) pour mémoriser les données à écrire dans une page, **caractérisée en ce que** ladite page est une colonne de la mémoire.

10. Architecture mémoire selon la revendication 9, **caractérisée en ce que** les moyens d'écriture en mode page comprennent un latch (LCG₀,..., LCGₘ) par colonne du plan mémoire non volatile pour contenir une information de sélection de page et un circuit logique de contrôle (6) pour fournir les signaux de sélection de rangées (Row₀,...Rowₚ) en fonction du contenu de la mémoire temporaire dans une phase d'écriture de la colonne du plan mémoire non volatile.

11. Architecture mémoire selon la revendication 10, **caractérisée en ce que** les latchs pour mémoriser l'information de sélection de page sont des latchs haute tension.

12. Architecture mémoire selon la revendication 11, **caractérisée en ce que** chaque latch (LCG₀,...,LCGₘ) est commandé en écriture par un signal de sélection de colonne correspondant (Selcol₀,...Selcolₘ), l'information de sélection de page qu'il contient permettant l'application d'une haute tension dans une phase d'effacement, uniquement sur la colonne correspondant à la page sélectionnée.

13. Architecture mémoire selon l'une des revendications 9 à 12, **caractérisée en ce que** le circuit logique de contrôle comprend des moyens (10,11,12) pour fournir successivement les signaux de sélection de rangées (Row₀,...Rowₚ) ligne de bit par ligne de bit, en fonction du bit d'information correspondant dans chacun des mots de la mémoire temporaire, permettant la programmation sélective de rangées de la mémoire non volatile.

14. Architecture mémoire selon la revendication 13, **caractérisée en ce que** chaque mot dans la mémoire temporaire (MT) comprend des bits d'information (DATABIT₀,...,DATABIT₇) correspondant à la donnée à écrire et un bit d'information de position (POSBIT) du mot, le circuit logique de contrôle (6) comprenant des moyens (10,11,12) activés par un signal de commande logique d'effacement (erase) pour fournir des signaux de sélection de rangées (Row₀,...,Rowₚ) correspondant aux bits d'information de position (POSBIT) contenus en mémoire temporaire (MT), permettant l'effacement sélectif des rangées de la mémoire non volatile.

15. Architecture mémoire selon la revendication 14, **caractérisée en ce que** les moyens pour fournir successivement des signaux de sélection de rangées ligne de bit par ligne de bit, pour la programmation sélective de rangées prennent en compte le bit de position de chacun des mots de la mémoire temporaire.

16. Architecture mémoire selon l'une des revendications 13 à 15, **caractérisée en ce qu'**elle comprend des moyens (CLKGEN) pour fournir un signal logique de phase (Clk0,...Clk7) et un signal de phase haute tension correspondant (HClk0,...HClk7) pour séquencer la programmation de chaque ligne de bit, ces signaux étant respectivement appliqués au circuit logique de contrôle (6) et à un circuit de commutation (MUXHV₀,..., MUXHVₘ) d'une haute tension sur les lignes de bit.

## Patentansprüche

1. Schreibverfahren im Seitenmodus für einen nicht flüchtigen, elektrisch löschbaren und programmierbaren Speicher in einem integrierten Schaltkreis, der eine Speicherstruktur (5) umfaßt, die in Spalten (Colₒ, ..., Colₘ) und Zeilen (Wlₒ, ..., Wlₚ) von Speicherworten als Matrix organisiert ist, wobei jedes Speicherwort eine Vielzahl von Speicherzellen (C0, ..., C7), die jeweils einer Bitleitung (Bl₀, ..., Bl₇) zugeordnet sind, sowie einen Zeilendekoder (DECX) und einen Spaltendekoder (DECY) umfaßt, die jeweils Zeilenauswahlsignale (Row₀, ..., Rowₚ) und Spaltenauswahlsignale (Selcol₀, ..., Selcolₘ) bereitstellen, welche das Anlegen geeigneter Spannungsniveaus gestatten, um auf die Speicherstruktur lesend oder schreibend zuzugreifen, wobei Mittel zum Schreiben im Seitenmodus einen temporären Speicher (MT) umfassen, um die Daten während des Schreibens in einer Seite zu speichern, **dadurch gekennzeichnet, daß** das Verfahren das Auswählen einer Spalte des Speichers als zu beschreibende Seite umfaßt.

2. Schreibverfahren nach Anspruch 1, welches umfaßt:
- eine Initialisierungsphase, die das Schreiben einer Seitenauswahl-Information bezüglich der zu schreibenden Seite in einen Speicherlatch, das mit einer Spalte der nicht flüchtigen Speicherstruktur verknüpft ist, und das Schreiben jedes in die Seite zu schreibenden Datums in einen temporären Speicher umfaßt, und
- eine Schreibphase zum Schreiben des Inhalts des temporären Speichers (MT) in die ausgewählte Seite.

3. Schreibverfahren nach Anspruch 2, **dadurch gekennzeichnet, daß** ein Hochspannungslatch pro Spalte der nicht flüchtigen Speicherstruktur verwendet wird, um die Seitenauswahl-Information zu speichern.

4. Schreibverfahren nach Anspruch 3, **dadurch gekennzeichnet, daß** der Spaltendekoder (DECY) während der Initialisierungsphase am Eingang eine Spaltenadresse empfängt und am Ausgang ein Zeilenauswahlsignal (Selcolᵢ) bereitstellt, das dem Auslösen des Schreibens des Seitenauswahl-Informationsbits in dem jeweiligen Hochspannungslatch (LCGᵢ) entspricht.

5. Schreibverfahren nach einem der vorangegangenen Ansprüche, **dadurch gekennzeichnet, daß** die Schreibphase einen Löschschritt und einen Programmierschritt umfaßt und daß der Programmierschritt Bitzeile für Bitzeile der ausgewählten Spalte durchgeführt wird, wobei jeder Programmierschritt einer Bitzeile abhängig von dem jeweiligen Informationsbit in jedem Wort, das in dem temporären Speicher enthalten ist, das Erzeugen von Zeilenauswahlsignalen (Row₀, ..., Rowₚ) umfaßt.

6. Verfahren nach Anspruch 5, **dadurch gekennzeichnet, daß** jedes Wort in dem temporären Speicher (MT) Informationsbits (DATABIT₀, ..., DATABIT₇), die dem zu schreibenden Datum entsprechen, sowie ein Positionsbit (POSBIT) des Wortes innerhalb der Seite umfaßt, und daß die Löschphase das Erzeugen von Zeilenauswahlsignalen (Row₀, ..., Rowₚ) umfaßt, die von den Bits der Positionsinformation abhängen, welche in dem temporären Speicher enthalten sind.

7. Schreibverfahren nach Anspruch 6, **dadurch gekennzeichnet, daß** das Erzeugen der Zeilenauswahlsignale (Row₀, ..., Rowₚ) in jedem Programmierschritt einer Bitzeile zudem von dem Positionsbit in jedem der Worte abhängt, welche in dem temporären Speicher enthalten sind.

8. Schreibverfahren nach einem der Ansprüche 5 bis 7, **dadurch gekennzeichnet, daß** während der Löschphase die Seitenauswahlinformation, die in einem der Latches der Auswahlseiten gespeichert ist, das Anlegen einer hohen Spannung an die so ausgewählten Spalte gestattet.

9. Architektur eines nicht flüchtigen, elektrisch programmierbaren und löschbaren Speichers in einem integrierten Schaltkreis, der eine Speicherstruktur (5) umfaßt, die in Spalten (Col₀, ..., Colₘ) und Zeilen (Wl₀, ..., Wlₚ) von Speicherworten als Matrix organisiert ist, wobei jedes Speicherwort eine Vielzahl von Speicherzellen (C0, ... C7), die jeweils einer Bitleitung (Bl₀, ..., Bl₇) zugeordnet sind, sowie einen Zeilendekoder (DECX) und einen Spaltendekoder (DECY) umfaßt, die entsprechend Zeilenauswahlsignale (Row₀, ..., Rowₚ) und Spaltenauswahlsignale (Selcol₀, ..., Selcolₘ) bereitstellen, welche das Anlegen von geeigneten Spannungsniveaus gestatten, um auf die Speicherstruktur zum Lesen oder zum Schreiben zuzugreifen, und ferner Mittel zum Schreiben im Seitenmodus umfaßt, die einen temporären Speicher (MT) aufweisen, um die zu schreibenden Daten in einer Seite zu speichern, **dadurch gekennzeichnet, daß** diese Seite eine Spalte des Speichers ist.

10. Speicherarchitektur nach Anspruch 9, **dadurch gekennzeichnet, daß** die Mittel zum Schreiben im Seitenmodus ein Latch (LCG₀, ..., LCGₘ) pro Zeile der nicht flüchtigen Speicherstruktur umfassen, um eine Seitenauswahl-Information aufzunehmen, sowie einen logischen Steuerschaltkreis (6), um die Zeilenauswahlsignale (Row₀, ..., Rowₚ) in Abhängigkeit des Inhalts des temporären Speichers in einem Schreibschritt der Spalte der nicht flüchtigen Speicherstruktur bereitzustellen.

11. Speicherarchitektur nach Anspruch 10, **dadurch gekennzeichnet, daß** die Latches zum Speichern der Seitenauswahlinformation Hochspannungslatches sind.

12. Speicherarchitektur nach Anspruch 11, **dadurch gekennzeichnet, daß** beim Schreiben jedes Latch (LCG₀, ..., LCGₘ) von einem Spaltenauswahlsignal (Selcol₀, ..., Selcolₘ) gesteuert wird, welches der Seitenauswahl-Information entspricht, deren Inhalt in einer Löschphase das Anlegen einer hohen Spannung lediglich an die Spalte, welche der ausgewählten Seite entspricht, gestattet.

13. Speicherarchitektur nach einem der Ansprüche 9 bis 12, **dadurch gekennzeichnet, daß** der logische Steuerschaltkreis Mittel (10, 11, 12) zum sukzessiven Ausgeben der Zeilenauswahlsignale (Row₀, ..., Rowₚ) Bitleitungs-weise als Funktion eines entsprechenden Informationsbits in jedem Wort des temporären Speichers umfaßt, wodurch eine zeilenselektive Programmierung des nicht flüchtigen Speichers ermöglicht wird.

14. Speicherarchitektur nach Anspruch 13, **dadurch gekennzeichnet, daß** jedes Wort in dem temporären Speicher (MT) Informationsbits (DATABIT₀, ..., DATABIT₇) umfaßt, die den zu schreibenden Daten und einem Positionsinformationsbit des Wortes entsprechen, wobei der logische Steuerschaltkreis (6) Mittel (10, 11, 12) umfaßt, die von einem logischen Löschsteuersignal (erase) aktiviert werden, um Zeilenauswahlsignale (Row₀, ..., Rowₚ) auszugeben, die den Positionsinformationsbits (POSBIT) entsprechen, welche in dem temporären Speicher (MT) enthalten sind, wodurch eine zeilenselektive Löschung des nicht flüchtigen Speichers gestattet wird.

15. Speicherarchitektur nach Anspruch 14, **dadurch gekennzeichnet, daß** die Mittel zum sukzessiven, Bitleitungs-weisen Ausgeben der Zeilenauswahlsignale das Positionsbit jedes Wortes in dem temporären Speicher berücksichtigen, um zeilenselektiv zu programmieren.

16. Speicherarchitektur nach einem der Ansprüche 13 bis 15, **dadurch gekennzeichnet, daß** die Speicherarchitektur Mittel (CLKGEN) zum Bereitstellen eines logischen Phasensignals (Clk0, ..., Clk7) und eines entsprechenden Phasensignals hoher Spannung (HClk0, ..., HClk7) umfaßt, um die Programmierung jeder Bitleitung fortlaufend zu steuern, wobei diese Signale jeweils an den logischen Steuerschaltkreis (6) und an einen Hochspannungs-Verbindungsschaltkreis (MUXHV₀, ..., MUXHVₘ) über die Bitleitungen angelegt werden.

## Claims

1. Method for writing in page mode to a non-volatile electrically erasable and programmable memory in an integrated circuit, comprising a memory plane (5) organised as a matrix in columns (Col₀, ..., Colₘ) and rows (Wl₀, ..., Wlₚ) of memory words, each memory word comprising a plurality of memory cells (C0, ..., C7) each associated with a bit line, (Bl₀, ..., Bl₇), a row decoder (DECX) and a column decoder (DECY) respectively supplying row (Row₀, ..., Rowₚ) and column (Selcol₀, ..., Selcolₘ) selection signals allowing the application of voltage levels appropriate for access to the memory plane in read or write mode, means for writing in page mode comprising a temporary memory (MT) for storing the data to be written in a page, **characterised in that** the method comprises the selection of a column of the memory as a page to be written.

2. Writing method according to Claim 1, **characterised in that** it comprises:
- an initialisation phase, comprising the writing of page selection information to be written in a storage latch associated with a column of the non-volatile memory plane and the writing in a temporary memory (MT) of each of the data items to be written in the page,
- a phase of writing the content of the temporary memory (MT) in the selected page.

3. Writing method according to Claim 2, **characterised in that** it comprises the use of a high-voltage latch per column of the non-volatile memory plane in order to store the page selection information.

4. Writing method according to Claim 3, **characterised in that**, in the initialisation phase, the column decoder (DECY) receives as an input a column address and provides as an output a corresponding column selection signal (Selcolᵢ) triggering the writing of the page selection information bit in the corresponding high-voltage latch (LCGᵢ).

5. Writing method according to one of the preceding claims, **characterised in that** the writing phase comprises an erasure phase and a programming phase and **in that** the programming phase is carried out bit line by bit line in the selected column, each stage of programming a bit line comprising the generation of the row selection signals (Row₀, ..., Rowₚ) as a function of the corresponding information bit in each of the words contained in temporary memory.

6. Method according to Claim 5, **characterised in that** each word in the temporary memory (MT) comprises information bits (DATABIT₀, ..., DATABIT₇) corresponding to the data item to be written and a position bit (POSBIT) for the word in the page and **in that** the erasure phase comprises the generation of the row selection signals (Row₀, ..., Rowₚ) as a function of the position information bits contained in temporary memory.

7. Writing method according to Claim 6, **characterised in that** the generation of the row selection signals (Row₀, ..., Rowₚ) at each stage of programming of a bit line is also a function of the position bit in each of the words contained in temporary memory.

8. Writing method according to one of the preceding Claims 5 to 7, **characterised in that**, in the erasure phase, the page selection information stored in one of the page selection latches allows the application of high voltage to the column thus selected.

9. Architecture of a non-volatile electrically programmable and erasable memory in an integrated circuit, comprising a memory plane (5) organised as a matrix in columns (Col₀, ..., Colₘ) and rows (Wl_{0,} ..., Wlₚ) of memory words, each memory word comprising a plurality of memory cells (C0, ..., C7) each associated with a bit line (Bl₀, ..., Bl₇), a row decoder (DECX) and a column decoder (DECY) respectively supplying row (Row₀, ..., Rowₚ) and column (Selcol₀, ..., Selcolₘ) selection signals allowing the application of voltage levels appropriate for access to the memory plane in read or write mode, means for writing in page mode of the means for writing in page mode comprising a temporary memory (MT) in order to store the data to be written in a page, **characterised in that** said page is a column of the memory.

10. Memory architecture according to Claim 9, **characterised in that** the means for writing in page mode comprise a latch (LCG₀, ..., LCGₘ) per column of the non-volatile memory plane in order to contain page selection information and a logical control circuit (6) in order to supply the row selection signals (Row₀, ..., Rowₚ) as a function of the content of the temporary memory in a writing phase of the column of the non-volatile memory plane.

11. Memory architecture according to Claim 10, **characterised in that** the latches for storing the page selection information are high-voltage latches.

12. Memory architecture according to Claim 11, **characterised in that** each latch (LCG₀, ..., LCGₘ) is controlled in write mode by a corresponding column selection signal (Selcol₀, ..., Selcolₘ), the page selection information that it contains allowing the application of high voltage in an erasure phase, solely on the column corresponding to the selected page.

13. Memory architecture according to one of Claims 9 to 12, **characterised in that** the logical control circuit comprises means (10, 11, 12) for successively supplying the row selection signals (Row₀, ..., Rowₚ) bit line by bit line, as a function of the corresponding information bit in each word of the temporary memory, allowing the selective programming of rows of the non-volatile memory.

14. Memory architecture according to Claim 13, **characterised in that** each word in the temporary memory (MT) comprises information bits (DATABIT₀, ..., DATABIT₇) corresponding to the data item to be written and an information position bit (POSBIT) for the word, the logical control circuit (6) comprising means (10, 11, 12) activated by a logical erasure control signal (erase) in order to supply row selection signals (Row₀, ..., Rowₚ) corresponding to the position information bits (POSBIT) contained in temporary memory (MT), allowing the selective erasure of the rows of the non-volatile memory.

15. Memory architecture according to Claim 14, **characterised in that** the means for successively supplying row selection signals bit line by bit line, for the selective programming of rows take into account the position bit of each of the words of the temporary memory.

16. Memory architecture according to one of Claims 13 to 15, **characterised in that** it comprises means (CLKGEN) for supplying a logical phase signal (Clk0, ..., Clk7) and a corresponding high-voltage phase signal (HClk0, ..., HClk7) for sequencing the programming of each bit line, these signals being respectively applied to the logical control circuit (6) and a switching circuit (MUXHV₀, ..., MUXHVₘ) for high voltage on the bit lines.
